Europäisches Patentamt

European Patent Office

Office européen des brevets

(19)

(11) Publication number: 0 397 194
A2

(12) EUROPEAN PATENT APPLICATION

(21) Application number: 90108913.6

(22) Date of filing: 11.05.90

(51) Int. Cl.5: G11C 11/00, G11C 16/04,
G11C 16/06

(30) Priority: 12.05.89 JP 119506/89

(43) Date of publication of application:
14.11.90 Bulletin 90/46

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Matsumoto. Osamu, c/o Intellectual
Property Div.
Kabushiki Kaisha Toshiba, 1-1 Shibaura
1-chome
Minato-ku, Tokyo 105(JP)
Inventor: Murata, Hiroyoshi, c/o Intellectual
Property Div.
Kabushiki Kaisha Toshiba, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
D-8000 München 81(DE)

(54) Semiconductor memory device having two types of memory cell.

(57) In the semiconductor memory device, a plurality memory cells (34) for storing data to be read out in the normal read mode and a plurality of memory cells (44) for storing flag data to be read out in another read mode are arranged in matrix on the same memory cell array (36). Each memory cell (34, 44) has a source connected to the ground, a drain connected to a bit line (40), and a gate. The gate of the memory cell (34) is connected to a word line (42), and the gate of the memory cell (44) is connected to a word line (46). In both read modes, the decoder circuit (50) changes the voltage level in accordance with a selection signal from the pulse generating circuit (56), so as to select one of the word lines (42, 46). The writing circuit (48) selects a desired bit line (40), so that data is written into the memory cells (34, 44), read out therefrom by the sense amplifier (52), and output to an external device.

FIG. 2

## Semiconductor memory device having two types of memory cell

This invention relates to a programmable semiconductor memory device including a flag memory cell, and more particularly, to a semiconductor memory device having at least two types of memory cells, from which data can be read in different modes.

Recently, the programmable semiconductor memory device has been used, in which a flag circuit is incorporated for temporarily or eternally storing state of a memory or calculation result in an operation mode. In general, one memory chip has two to ten flag circuits, which store flag data "0" and "1". The flag data is used as a security against reading/writing data out of/into the chip (see Lattice Semiconductor Corp. "HIGH PERFORMANCE E2CMOS GENERIC ARRAY LOGIC").

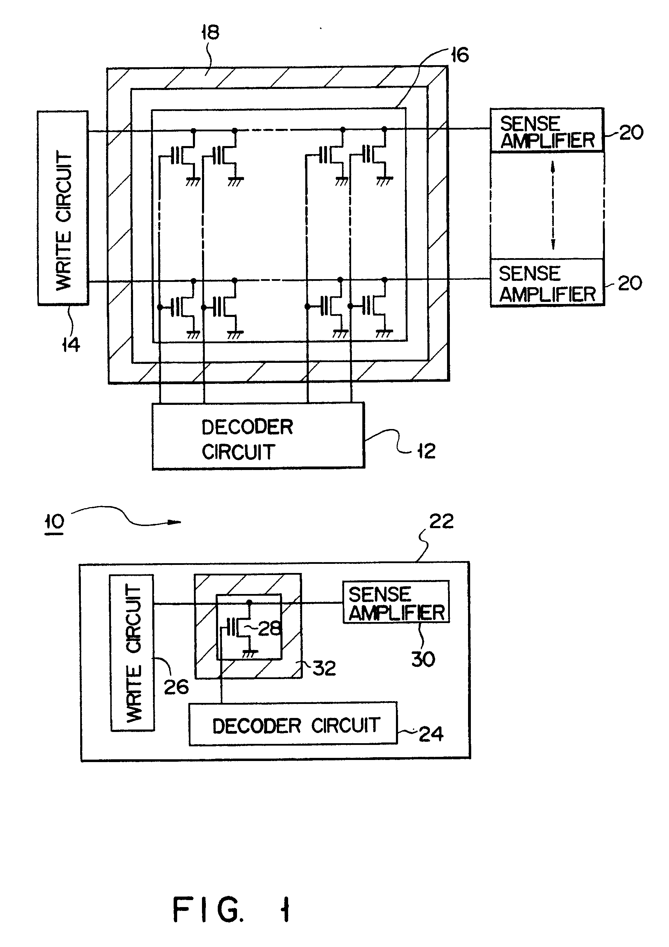

Fig. 1 is a circuit diagram showing the main portion of a conventional EPROM (erasable programmable read only memory) chip 10 and a flag circuit 22 incorporated in the chip.

As is shown in Fig. 1, the chip 10 includes a memory cell array 16 which is controlled by both a decoder 12 and a write circuit 14. A guard ring diffusion section 18 is formed around the memory cell array 16 to prevent latch-up. A sense amplifier 20 for detecting data stored in the memory cell array 16 is formed outside the guard ring diffusion section 18.

The flag circuit 22 is located in the vicinity of the memory cell array 16, and includes a decoder 24 for exclusively decoding flag data, a write circuit 26 and a memory cell 28. A guard ring diffusion section 32 surrounds the memory cell 28 to prevent latch-up. The data stored in the memory cell 28 is read out by an exclusive sense amplifier 30. Thus, the exclusive sense amplifier 30 is controlled in a read mode different from the normal read mode in which data is read from the memory cell incorporated in the memory cell array 16.

If a number of flag circuits 22 are included in the chip 10, each must have a memory cell 28, a guard ring diffusion section 32, a sense amplifier 30, a decoder circuit 24, and a write circuit 26. Thus, since a great many circuits are required and the wiring is complex, the area of the chip must be large. This has been a serious determent to cost reduction. Moreover, if the memory cells 28 of the flag circuit are scattered in the chip 10, the characteristics of the flags vary, resulting in low reliability of the device.

As may be understood from the above, in the conventional memory device, the memory cell of the flag circuit is independent of the memory cell array of the chip 10. For this reason, a sense amplifier and a write circuit exclusive to the flag circuit must be additionally provided. Accordingly, the chip must have a large area and much cost is required to manufacture the memory device. Further, the memory cells scattered in the chip cause changes in characteristic of the device and degrade the reliability of the device.

It is therefore an object of the present invention to provide a programmable semiconductor memory device which does not require a sense amplifier or a write circuit exclusive to a flag circuit, and which can be manufactured at low cost without increasing the chip area.

According to an aspect of the present invention, there is provided a semiconductor memory device having a memory cell array comprising: a plurality of first memory cells for storing data to be read out in a first read mode, each of the memory cells including a drain, a gate, and a source connected to a low potential; a plurality of second memory cells for storing data to be read out in a second read mode, each of said memory cells including a drain, a gate, and a source connected to a low potential; at least one bit line connected to the drains of the first and second memory cells; at least one first word line connected to the gates of the first memory cells; at least one second word line connected to the gates of the second memory cells; selecting means, connected to the first and second word lines, for selecting a desired word line by changing the voltage level; and writing means and reading means, connected to the bit lines, for selecting a desired bit line.

This invention can be more fully understood from the following detailed description when taken in conjunction with the accompanying drawings, in which:

Fig. 1 is a circuit diagram showing the semiconductor memory device of prior art;

Fig. 2 is a circuit diagram showing the semiconductor memory device according to an embodiment of the present invention; and

Figs. 3A and 3B are timing charts showing the operation of a portion of the semiconductor memory device shown in Fig. 2.

An embodiment of the present invention will now be described in detail with reference to the accompanying drawings.

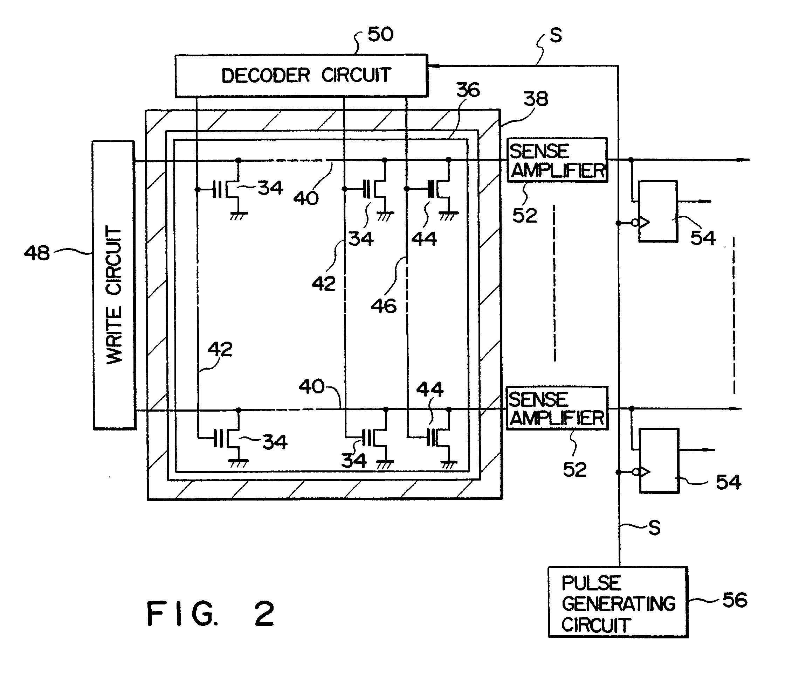

Fig. 2 is a circuit diagram showing the semiconductor memory device according to an embodiment of the present invention, in which a memory cell array and peripheral circuits are illustrated.

In Fig. 2, a memory cell array 36 includes a plurality of EPROM (erasable programmable read only memory) cells 34 arranged in matrix. Each of the memory cells 34 includes a non-volatile transistor. Data for use in, for example, programming are stored in the memory cells 34 and read out therefrom in the normal read mode. A guard ring diffusion section 38 for preventing latch-up is formed around the memory cell array 36. The drains of the memory cells 34 in the same row are connected to the same bit line 40, and the gates thereof in the same column are connected to the same word line 42. All of the sources thereof are connected to the ground.

The memory cell array 36 also includes a column of memory cells 44. The drains of the memory cells 44 are respectively connected to the bit lines 40, and the sources thereof are all connected to the ground. The gates of the memory cells 44 are connected to a word line 46, i.e. one of the word lines 42. The memory cells 44 store, for example, flag data, which is read out in a mode different from the normal read mode.

The bit lines are connected to a writing circuit 48 for selecting a row, via a guard ring diffusion section 38. The word lines 42 and 46 are connected to a decoder circuit 50 also via the guard ring diffusion section 38. On the periphery of the guard ring diffusion section 38 are provided a plurality of sense amplifiers 52, which are connected to the bit lines 40, respectively. The outputs of the sense amplifiers 52 are supplied to an external device as read-out data, and also to a plurality of latch circuits 54. The latch circuits 54 are connected to a pulse generating circuit 56, which supplies a latch control signal to the latch circuits 54.

The pulse generating circuit 56, which is also connected to the decoder circuit 50, outputs a pulse signal S. The pulse signal S is supplied to the decoder circuit 50 as a selection signal for selecting the word line 46 to which all of the gates of the memory cells 44 are connected. When the pulse signal S is supplied to the decoder circuit 50 from the pulse generating circuit 56, the decoder circuit 50 sets the word lines 42 to the ground (GND) level and the word line 46 to the source voltage (Vcc) level.

Next, the operation of the semiconductor memory device thus arranged will be described below.

Data is written into the memory cells 34 in the memory cell array 36 and the memory cells 44 for flag data in the following manner. One of the word lines 42 and 46 is selectively activated by the row decoder 50 in accordance with the program for writing data into the memory cells 34 and 44. As a result of the selective activation of the word lines 42 or 46, one memory cell 34 or one memory cell 44 is selected for every bit line. At this time, a high voltage is applied to both of the drain and the gate of the selected memory cell 34 or 44, thereby injecting electrons to the floating gate of the nonvolatile transistor. As a result, data, for example "0" is written into the memory cell.

Data is read from the memory cells 34 by the row decoder 50, which selects a desired word line 42, thereby selecting one memory cell 34 corresponding to the selected word line 42. At this time, in the memory cell 34, a predetermined reading voltage is applied to the drain and a predetermined selecting voltage is applied to the gate. The predetermined reading voltage is generated from a load circuit (not shown).

If data "0" has been written in the selected memory cell 34, the memory cell 34 cannot be in an ON state, since the threshold voltage is high. On the other hand, if data "0" has not been written in the memory cell 34, the memory cell 34 can be in an ON state, since the threshold voltage is low. When the memory cell is in an ON state, the potential of each bit line 40 is amplified by the sense amplifier 52. Thus, data is detected and output to an external device.

Data is read from the flag memory cells 44 in the following manner. Assume that data has been programmed beforehand in the memory cells 44.

The flag data is read out from a memory cell 44 through the sense amplifier 52 common to the memory cells 34. The sense amplifier 52 is designed to read out memory data from a selected memory cell 34 in the normal data reading mode, in which data other than flag data is read out, and to read out memory data from a flag memory cell 44 in the flag data reading mode.

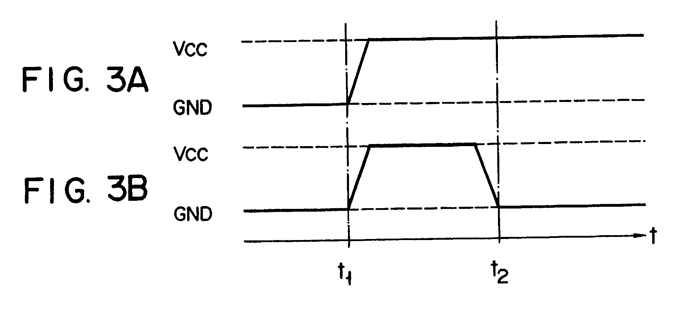

Figs. 3A and 3B are timing charts of a control signal (pulse signal) S. When power is applied ($t_1$) as shown in Fig. 3A, the pulse generating circuit 56 detects rise of the power voltage. In accordance with the detection, the pulse generating circuit 56 generates a pulse signal S as shown in Fig. 3B. During the period ($t_1$-$t_2$) in which the pulse signal S is being output, the decoder circuit 50 outputs a voltage of the GND level to each word line 42, and a voltage of the Vcc level to the word line 46 to which the gates of the flag memory cells 44 are connected. Thus, the flag memory cells 44 are selected and the content thereof is read out through the sense amplifier 52 by an external device. When the pulse signal S falls from the Vcc level to the GND level ($t_2$), the latch circuit 54 is triggered, and latches the output of the sense amplifier 52. After then, even when data is read from the normal memory cell 34, the latch circuit 54 keeps storing the content of the flag memory cell, and even if the power is turned off, the state is maintained, until power is applied again.

In the above embodiment, flag data is latched in accordance with a pulse signal generated in the power applying mode. However, a pulse signal generated in any other desired mode can be used for the same purpose.

As has been described above, since the memory cells for storing flag data are located in the memory cell array, the area occupied by the flag circuit is considerably smaller than that of the conventional flag circuit, thereby reducing the pattern area of the chip.

In addition, since the flag memory cells are located in the vicinity of each other in a portion of the memory cell array, the change in the characteristic of the device is suppressed to a minimum range.

Further, according to the semiconductor memory device as described above, the more flags can be formed than those in the conventional device. Moreover, any one of the bit and word lines can be prohibited from operating, the output of the device can be controlled and the polarity of the output can be reversed. Thus, flags can be used for various purposes.

Reference signs in the claims are intended for better understanding and shall not limit the scope.

## Claims

1. A semiconductor memory device having a memory cell array comprising: a plurality of first memory cells for storing first data which is to be read out in a first read mode, each of the memory cells having a source, a drain, and a gate, the source connected to a low potential; at least one first bit line connected to the drains of the first memory cells; at least one first word line connected to the gates of the first memory cells; a first selecting means, connected to the first word lines, for selecting a desired word line; a first writing means and a first reading means, connected to the first bit lines, for selecting a desired bit line; a second memory cell for storing second data which is to be read out in a second read mode different from the first read mode, the memory cell having a source, a drain, and a gate, the source connected to a low potential; a second bit line connected to the drain of the second memory cell; a second word line connected to the gate of the second memory cell; a second selecting means, connected to the second word line, for reading out data therefrom; and a second writing means and a second reading means, connected to the second bit line, for supplying data thereto;
characterized in that a plurality of the second memory cells (44) are provided, the drain of each cell is connected to the first bit line, said second word line (46) and said first word line (42) are connected to said first selecting means (50), and said first selecting means (50) changes the voltage level, thereby selecting a desired word line.

2. A device according to claim 1, characterized in that said first memory cells (34) and the second memory cells (44) are arranged in matrix on said memory cell array (36).

3. A device according to claim 1, characterized in that said selecting means (50) supplies an output of the source voltage level to said first word line (42), and an output of the ground voltage level to said second word line (46), so that the first data is read out, and supplies an output of the ground voltage level to said first word line (42), and an output of the source voltage level to said second word line (46), so that the second data is read out.

4. A device according to claim 1, characterized in that said second memory cells (44) are flag memory cells.

5. A device according to claim 1, further comprising latch means (54) for latching second data read out from said second memory cells (44).

6. A device according to claim 5, characterized in that said latch means (54) latches second data read out from said second memory cells (44) in accordance with a signal in the second read mode.

7. A device according to claim 1, further comprising signal generating means (56) for generating and supplying a selection signal to select one of said first and second word lines (42,46) to said selecting means (50), which selects one of said first and second word lines (42,46) in accordance with the selection signal.

8. A device according to claim 7, characterized in that said signal generating means generates the selection signal immediately after the power is applied.

FIG. 1

FIG. 2

FIG. 3A

FIG. 3B